# EUROPEAN PATENT SPECIFICATION

(11) **EP 1 818 351 B1**
(45) Date of publication and mention of the grant of the patent: **24.06.2009**
(21) Application number: 07002620.8
(22) Date of filing: 07.02.2007
(51) Int. Cl.: C08G 59/68, C08L 63/00, H01L 21/56

(54) **Underfill encapsulant for wafer packaging and method for its application**
Unterfüllungsverkapselungsmittel zum Verpacken von Wafern und Verfahren zu seiner Anwendung
Agent d'encapsulation de sous-remplissage pour emballage de plaque et procédé pour son application

(30) Priority: 10.02.2006 US 351647
(43) Date of publication of application: 15.08.2007
(73) Proprietor: Henkel AG & Co. KGaA, 40589 Düsseldorf (DE)
(72) Inventor: Yue Xiao, Allison, Belle Mead New Jersey 08502 (US); Dutt, Gyanendra, Piscataway, New Jersey 08854 (US)
(74) Representative: Held, Stephan

(56) References cited:
- EP-A1- 1 203 781
- EP-A1- 1 203 782
- WO-A-03/075338
- US-A1- 2003 149 135
- US-A1- 2004 087 681

## Description

### RELATED APPLICATIONS

The present application is a continuation-in-part application of United States pending patent application Serial Number 10/084,869, filed March 1, 2002.

### FIELD OF THE INVENTION

The present invention is related to an underfill encapsulant and a method for its application to semiconductor wafers.

### BACKGROUND OF THE INVENTION

This invention relates to underfill encapsulant compounds prepared from epoxies to protect and reinforce the interconnections between an electronic component and a substrate in a microelectronic device. Microelectronic devices contain multiple types of electrical circuit components, mainly transistors assembled together in integrated circuit (IC) chips, but also resistors, capacitors, and other components. These electronic components are interconnected to form the circuits, and eventually are connected to and supported on a carrier or a substrate, such as a printed wire board. The integrated circuit component may comprise a single bare chip, a single encapsulated chip, or an encapsulated package of multiple chips. The single bare chip can be attached to a lead frame, which in turn is encapsulated and attached to the printed wire board, or it can be directly attached to the printed wire board. These chips are originally formed as a semiconductor wafer containing multiple chips. The semiconductor wafer is diced as desired into individual chips or chip packages.

Whether the component is a bare chip connected to a lead frame, or a package connected to a printed wire board or other substrate, the connections are made between electrical terminations on the electronic component and corresponding electrical terminations on the substrate. One method for making these connections uses polymeric or metallic material that is applied in bumps to the component or substrate terminals. The terminals are aligned and contacted together and the resulting assembly is heated to reflow the metallic or polymeric material and solidify the connection.

During its normal service life, the electronic assembly is subjected to cycles of widely varying temperature ranges. Due to the differences in the coefficient of thermal expansion for the electronic component, the interconnect material, and the substrate, this thermal cycling can stress the components of the assembly and cause it to fail. To prevent the failure, the gap between the component and the substrate is filled with a polymeric encapsulant, hereinafter called underfill or underfill encapsulant, to reinforce the interconnect material and to absorb some of the stress of the thermal cycling.

Two prominent uses for underfill technology are for reinforcing packages known in the industry as chip scale packages (CSP), in which a chip package is attached to a substrate , and flip-chip packages in which a chip is attached by an array of interconnections to a substrate.

In conventional capillary flow underfill applications, the underfill dispensing and curing takes place after the reflow of the metallic or polymeric interconnect. In this procedure, flux is initially applied on the metal pads on the substrate. Next, the chip is placed on the fluxed area of the substrate, on top of the soldering site. The assembly is then heated to allow for reflow of the solder joint. At this point, a measured amount of underfill encapsulant material is dispensed along one or more peripheral sides of the electronic assembly and capillary action within the component-to-substrate gap draws the material inward. After the gap is filled, additional underfill encapsulant may be dispensed along the complete assembly periphery to help reduce stress concentrations and prolong the fatigue life of the assembled structure. The underfill encapsulant is subsequently cured to reach its optimized final properties.

Recently, attempts have been made to streamline the process and increase efficiency by coating the underfill encapsulant directly on the semiconductor wafer before the wafer is diced into individual chips. The coating procedure, which can be performed via various methods, including screen printing, stencil printing and spin coating, allows for a single application of underfill to a single semiconductor wafer that is later diced into a large number of individual chips.

In order to be useful as a wafer level underfill encapsulant, the underfill must have several important properties. First, the material must be easy to apply uniformly on the wafer so that the entire wafer has a consistent coating. The underfill encapsulant that is applied to the wafer must not interfere with the clean dicing of the wafer into individual chips. The underfill encapsulant must be B-stageable, which means that the underfill must be solidified after its placement on a wafer to provide a smooth, non-tacky coating with minimal residual solvent.

If the starting underfill material is a solid, the solid is dispersed or dissolved in a solvent to form a paste and the paste applied to the wafer. The underfill is then heated to evaporate the solvent, leaving a solid, but uncured, underfill on the wafer. If the starting underfill material is a liquid or paste, the underfill is dispensed onto the wafer and heated to partially cure it to a solid state.

The B-stage process usually occurs at a temperature lower than about 150 °C without prematurely curing the underfill encapsulant. The final curing of the underfill encapsulant must be delayed until after the solder fluxing (in the situation that solder is the interconnect material) and interconnection, which occurs at a temperature of 183 °C in the case of tin/lead eutectic solder and greater than 200°C in the case of lead free solder. The final curing of the underfill should occur rapidly after the solder bump flow and interconnection. During this final attachment of the individual chips to a substrate, the underfill encapsulant must flow in order to enable fillet formation, flux the solder bumps, and provide good adhesion between the chip, or chip passivation layer, the substrate, or the solder mask, and the solder joints. In particular instances, it can be useful to provide an unfilled liquid curable fluxing material directly on the substrate to faciliate interconnection.

### BRIEF DESCRIPTION OF THE FIGURE

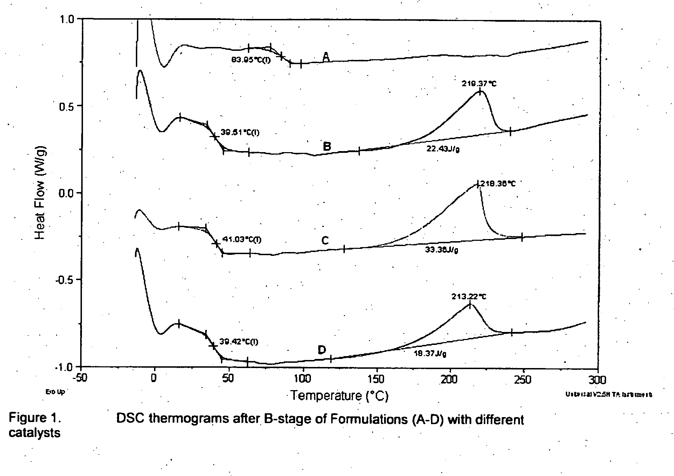

Figure 1 is DSC curing thermograms.

### SUMMARY OF THE INVENTION

The invention relates to a curable underfill encapsulant composition that is applied directly onto semiconductor wafers before the wafers are diced into individual chips. The composition comprises a thermally curable resin system comprising an epoxy resin, a solvent, an imidazole-anhydride catalyst, and optionally, fluxing agents. Various other additives, such as defoaming agents, wetting agents, adhesion promoters, flow additives and rheology modifiers may also be added as desired. In an alternative embodiment, the imidazole-anhydride catalyst is replaced with an imidazole phosphate salt. The underfill encapsulant is B-stageable to provide a coating on the wafer that is smooth, non-tacky and will allow the wafer to be cleanly diced into individual chips. The individual chips are then attached directly to a substrate.

### DETAILED DESCRIPTION OF THE INVENTION

The resins used in the underfill encapsulant composition of the present invention are curable compounds, which means that they are capable of polymerization. As used in this specification, to cure will mean to polymerize, with cross-linking. Cross-linking, as understood in the art, is the attachment of two-polymer chains by bridges of an element, a molecular group, or a compound, and in general takes place upon heating.

Ingredients of the B-stageable underfill encapsulant composition of the present invention include a blend of one or more epoxy resins, an imidazole-anhydride adduct which acts as a catalyst and one or more solvents. In the alternative embodiment, the imidazole-anhydride adduct is replaced with an imidazole phosphate salt that acts as a catalyst. Optionally, fluxing agents, air release agents, flow additives, adhesion promoters, rheology modifiers, surfactants and other ingredients may be included. The ingredients are specifically chosen to obtain the desired balance of properties for the use of the particular resins. A solvent is chosen to dissolve the resin(s) and thus make the composition into a paste form with proper viscosity for application via spin coating, screen printing or stencil printing on the wafer. In the preferred embodiment, the composition is B-stageable, i.e., the composition is capable of an initial solidification that produces a, smooth, non-tacky coating on the semiconductor wafer. The B-stage solidification preferably occurs in at a temperature in the range of about 80°C to about 160°C. After the B-stage process, a smooth, non-tacky solid coating is obtained on the wafer to ensure the clean dicing of the wafer into individual chips. The final, complete curing occurs at a second temperature of about 180°C or above, which is higher than the B-stage curing temperature. Generally, the final cure of the composition occurs after the formation of the interconnections. In the case of Pb/Sn eutectic solder, the formation of the interconnections occurs at a temperature above the melting point of the solder, which is 183 °C. In the case of lead free solder, the formation of the interconnections occurs at a temperature of about 217°C for AgSnCu and about 225°C for AgCu solder alloy. A latent catalyst, the adduct of anhydride and imidazole or imidazole phosphate salt, is used in the composition to ensure the proper cure of the composition without interfering with the formation of the interconnection. The catalyst chosen must prevent any curing, other than some minimal pre-curing, during the B-stage and must ensure that no gelation occurs on the non-tacky surface formed after the B-stage. Preferably, the B-stage solidification occurs at a temperature of at least 30 °C less than the final cure temperature. The catalyst must also allow for fluxing and curing in one reflow step. The underfill must first flux and then cure to ensure proper solder interconnect formation.

Examples of epoxy resins suitable for use in the present wafer level underfill composition include monofunctional and multifunctional glycidyl ethers of Bisphenol-A and Bisphenol-F, aliphatic and aromatic epoxies, saturated and unsaturated epoxies, or cycloaliphatic epoxy resins or a combination thereof. Examples of aliphatic epoxy include Flex Epoxy 1.

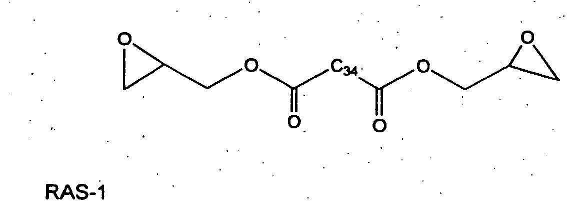

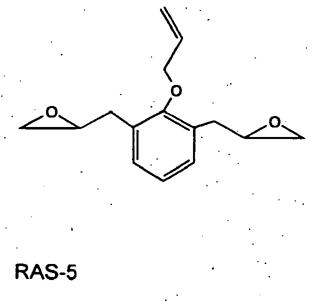

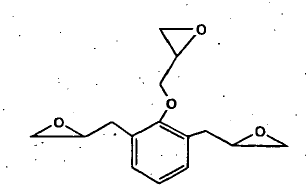

Example of aromatic epoxies include RAS-1, RAS-5 and Flex Epoxy3.

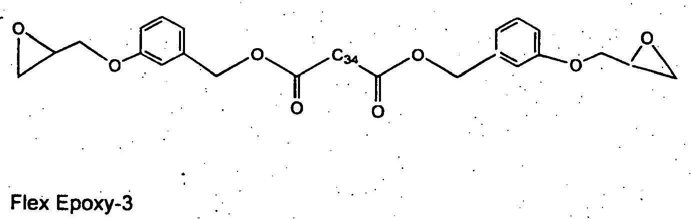

Example of unsaturated epoxy includes Cardolite NC513.

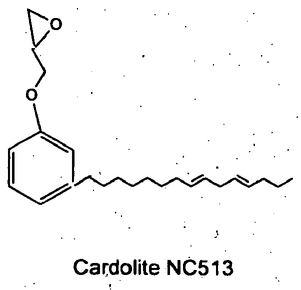

Examples of non-glycidyl ether epoxides include 3,4-epoxycyclohexylmethyl-3,4-epoxycyclohexane carboxylate, which contains two epoxide groups that are part of the ring structures and an ester linkage, vinylcyclohexene dioxide, which contains two epoxide groups and one of which is part of the ring structure, 3,4-epoxy-6-methyl cyclohexyl methyl-3,4-epoxycyclohexane carboxylate and dicyclopentadiene dioxide.

Glycidyl ether epoxides are preferred in the invention, either separately or in combination with the non-glycidyl ether epoxides. A preferred epoxy resin of this type is bisphenol A resin. Another preferred epoxy resin is bisphenol F type resin. A preferred epoxy novolac resin is poly(phenyl glycidyl ether)-co-formaldehyde. Biphenyl type epoxy resin may also be utilized in the present invention. This type of resin is commonly prepared by the reaction of biphenyl resin and epichlorohydrin. Dicyclopentadiene-phenol epoxy resin, naphthalene resins, epoxy functional butadiene acrylonitrile copolymers, epoxy functional polydimethyl siloxane and mixtures thereof are additional types of epoxy resins which may be employed. Commercially available bisphenol-F type resins are available from CVC Specialty Chemicals, Maple Shade, New Jersey, under the designation 8230E and Resolution Performance Products LLC under the designation RSL1739. Bisphenol-A type resin is commercially available from Resolution Technology as EPON 828, EPON 1001, EPON 1002, and a blend of bisphenol-A and bisphenol-F is available from Nippon Chemical Company under the designation ZX-1059. A further epoxy that may be utilized is XP71756.00, which is commercially available from Vantico.

In addition to the resins, an imidazole-anhydride adduct or imidazole phosphate salt is included in the underfill composition as a catalyst. The adduct provides different properties to the underfill than the properties provided by the inclusion of imidazole and anhydride as separate components. The salt provides different properties to the underfill than the properties provided by the inclusion of imidazole and phosphoric acid as separate components. Preferred imidazoles that may be included in the adduct or salt include non-N-substituted imidazoles such as 2-phenyl-4-methyl imidazole, 2-ethyl-4-methyl-imidazole, 2-phenyl imidazole, 2-methyl imidazole and imidazole. Other useful imidazole components include alkylsubstituted imidazole, N-substituted imidazole, N-methylimidazole and mixtures thereof. The salt also comprises a phosphoric acid component. Preferred catalysts include 2-phenyl-imidazole dihydrogen phosphate salt, commercially available from Air Products as AMICURE 2PIP and 2-heptadecylimidazole, commercially available from Curezol and CUREZOL 17A. The adduct also comprises an anhydride component. The preferred anhydride is preferably a cycloaliphatic anhydride and most preferably pyromellitic dianhydride, commercially available as PMDA from Aldrich. Additional preferred anhydrides include methylhexa-hydro phthalic anhydride, commercially available as MHHPA from Lonza Inc. Intermediates and Actives. Other anhydrides that may be utilized include methyltetrahydrophthalic anhydride, nadic methyl anhydride, hexa-hydro phthalic anhydride, tetra-hydro phthalic anhydride, phthalic anhydride, dodecyl succinic anhydride, bisphenyl dianhydride, benzophenone tetracarboxylic dianhydride, and mixtures thereof. A preferred catalyst is synthesized by combining 1 mole part 1,2,4,5-benzenetetracarboxylic dianhydride and 2 mole part 2-phenyl-4-methyimidazole. Both components are first dissolved in acetone under heat and when both are combined, the imidazole-dianhydride salt forms as a precipitate. This preferred catalyst, in combination with an epoxy and solvent, produces an underfill having an onset curing temperature well above 160°C and a cure peak temperature above 183 °C. Further, the preferred catalyst provides improved latency as opposed to the use of just an imidazole.

A fluxing agent may also be incorporated into the underfill composition. The fluxing agent primarily removes metal oxides and prevents reoxidation. While many different fluxing materials may be employed, the fluxing agent is preferably chosen from the group carboxylic acids. These carboxylic acids include rosin gum, dodecanedioic acid (commercially available as Corfree M2 from Aldrich), adipic acid, sebasic acid, polysebasic polyanhydride, maleic acid, tarrtaric acid, and citric acid. The flux agent may also be chosen from the group that includes alcohols, hydroxyl acid and hydroxyl base. Preferable fluxing materials include polyols such as ethylene glycol, glycerol, 3-[bis(glycidyl oxy methyl) methoxy]-1,2-propane diol, D-ribose, D-cellobiose, cellulose, 3-cyclohexene-1,1-dimethanol and similar materials. The strength of the acid is an important factor because the acid should be sufficiently strong to wash the oxides out of the solder and the substrate. Preferably, the pKₐ should be greater than 5. Stability of the acid at temperatures around 183 °C is important, and the acid should not decompose at temperatures lower than 183 °C. As solder reflows at 183 °C, a flux material that cannot withstand that temperature is unsuitable for the proper formulation.

A solvent is utilized to modify the viscosity of the composition. Preferably, the solvent will evaporate during the B-stage process which occurs at temperatures lower than about 150 °C. Common solvents that readily dissolve the epoxy resins, are non-reactive and have the proper boiling point ranging from 100 °C to 200 °C are preferable for use with this application. Examples of solvents that may be utilized include ketones, esters, alcohols, ethers, and other common solvents that are stable and dissolve the epoxy and phenolic resins in the composition. Preferred solvents include γ-butyrolactone and propylene glycol methyl ethyl acetate (PGMEA).

Additional ingredients may be added to the underfill encapsulant to produce a composition with the desired properties. For example, monofunctional reactive diluents can incrementally delay the increase in viscosity without adversely affecting the physical properties of the cured underfill. Preferred diluents include p-tert-butyl-phenyl glycidyl ether, allyl glycidyl ether, glycerol diblycidyl ether, glycidyl ether of alkyl phenol (commercially available from Cardolite Corporation as Cardolite NC513), and Butanediodiglycidylether (commercially available as BDGE from Aldrich), although other diluents may be utilized. Surfactants may be utilized to aid in the prevention of process voiding during the flip-chip bonding process and subsequent solder joint reflow and material curing. Various surfactants which may be utilized include organic acrylic polymers, silicones, polyoxyethylene/polyoxypropylene block copolymers, ethylene diamine based polyoxyethylene/polyoxypropylene block copolymers, polyol-based polyoxyalkylenes, fatty alcohol-based polyoxyalkylenes, fatty alcohol polyoxyalkylene alkyl ethers and mixtures thereof. In addition, coupling agents, air release agents, flow additives, adhesion promoters, inorganic fillers and other ingredients may also be added as desired.

A preferred embodiment of the underfill encapsulant of the present invention comprises at least one epoxy resin, an imidazole-anhydride adduct as a catalyst, a fluxing agent, solvent, and other ingredients as desired. The resin will comprise in the range of 20 wt % to about 90 wt % of the underfill composition. An imidazole-anhydride adduct is also added as a catalyst. The adduct comprises in the range of about 0.01 wt % to about 10 wt % of the underfill composition and preferably about 0.1 wt % to about 5 wt % of the composition. Optionally, a fluxing agent is added comprising in the range of about 0.5 wt % to about 20 wt % of the composition and preferably in the range of about 1 wt % to about 10 wt % of the composition. In addition, up to 80 wt % of solvent(s) may be added. Finally, optional ingredients such as surfactants, air release agents, flow additives, rheology modifiers, inorganic fillers and adhesion promoters may be added to the composition in the range of about 0.01 wt % to about 5 wt % of the composition.

A further preferred embodiment of the underfill encapsulant of the present invention comprises at least one epoxy resin, an imidazole phosphate salt as a catalyst, a fluxing agent, solvent, inorganic filler and other ingredients as desired. The epoxy resin will comprise in the range of about 20 wt% to about 80 wt% of the underfill composition. An imidazole phosphate salt is added as a catalyst. The imidazole phosphate salt comprises in the range of about 0.01 wt% to about 10 wt% of the underfill composition and preferably about 0.1 wt% to about 5 wt% of the composition. Optionally, a fluxing agent is added comprising in the range of about 0.5 wt% to about 20 wt% of the composition and preferably in the range of about 1 wt% to about 10 wt% of the composition. In addition, the composition contains up to about 70 wt% of filler content and up to about 60 wt% of solvent(s). Finally, optional ingredients such as surfactants, air release agents, flow additives, rheology modifiers, and adhesion promoters may be added to the composition in the range of about 0.01 wt% to about 5 wt% of the composition.

To utilize the B-stageable underfill composition, it is first applied directly onto a semiconductor wafer or individual chip via screen printing, spin coating or stencil printing. The wafer or chip having the coating is heated to an initial, B-stage temperature in the range of about 100 °C to about 140 °C for about 10 minutes to one hour so that the composition is B-stage solidified in the form of a smooth, non-tacky and void-free film. In the case of a wafer, the wafer is diced into individual chips. The chips having the B-staged composition are placed on a substrate with the B-staged composition adjacent to the substrate and the entire assembly is heated to a temperature of approximately 183 °C (in the case that lead/tin solder is utilized). This second heating causes the formation of interconnections between the substrate and the chip and the fluxing of the solder balls on the chip.

In an alternative embodiment, a composition comprising an unfilled liquid curable fluxing material comprising an epoxy resin, a phenolic-containing compound and an imidazole/anhydride adduct or an imidazole phosphate salt is applied directly to the substrate prior to placement of the chip. After the underfill is B-stage solidified on the wafer and the wafer is diced into individual chips, the chip is placed on the substrate with the B-staged material adjacent to and in contact with the unfilled liquid curable material. The unfilled liquid curable material facilitates improved solder fluxing and interconnections between the substrate and the individual chips. When the composition of the alternative embodiment is placed on a substrate and a chip having the B-stageable composition is placed on the substrate, a superior interconnect is formed after the completion of the reflow process.

The invention may be better understood by reference to the following examples:

EXAMPLE 1: Five underfill encapsulant compositions were formulated as set out in Table 1. To make each formulation, the epoxy was first dissolved into the solvent under heat. When clean rosin was used as the fluxing agent, as in formulation 1, it was added during this first step and heated until a homogenous epoxy-solvent-rosin mixture formed. The rosin that is added must first be treated to form a clean-rosin gum. The treatment consists of heating the commercial rosin in a vacuum oven to drive off any impurities to form a "clean" fluxing reagent. On the other hand, if Corfree M2 is used as the fluxing reagent, as in formulations 2-5, it is added only after the epoxy-solvent mixture has cooled to room temperature. The rest of the components (catalyst, wetting agent, and defoamer) are also added after the epoxy-solvent or epoxy-solvent-rosin material has cooled to room temperature. The material is then mixed thoroughly and vacuumed under room temperature to degas the underfill.

**Table 1: Underfill Formulations**

| No. | Epoxy Resin¹ | Solvent² | Fluxing Agent³ | Catalyst⁴ | Wetting Agent⁵ | Defoamer⁶ |
|---|---|---|---|---|---|---|
| 1 | 57.00 | 40.00 | 2.85 | 0.29 | 0.29 | 0.29 |
| 2 | 55.04 | 38.63 | 5.50 | 0.28 | 0.27 | 0.28 |
| 3 | 57.00 | 40.00 | 5.7 | 0.29 | 0.29 | 0.29 |
| 4 | 70.70 | 29.60 | 7.07 | 0.35 | 0.71 | 0.71 |
| 5 | 70.70 | 29.60 | 7.07 | 0.35 | 0.71 | 0.71 |

| | | | | | | |
|---|---|---|---|---|---|---|
| 1 EPON 1001 from Resolution Products for samples 1 - 3, and XP 71756, also known as Tactix556, from Vantico for samples 4 - 5 2 Solvent BLO (y-butyrolactone) for samples 1 - 4 and PGMEA (propylene glycol methyl ether acetate) for sample 5, both from Aldrich Chemical 3 Fluxing Agent clean rosin for sample 1 (vacuumed under heat to rid of impurities) ; Corfree M2 for sample 2-5 4 Catalyst is imidazole-anhydride adduct 5 Wetting Agent is G6715, 3-glycidoxypropylpentamethyl disiloxane from United Technologies 6 Defoamer BYK A500 (Chemie) for sample 1, phthalo blue (Plasticolors) for sample 2, and Agitan 731 (Ultra Additives) for samples 3-5. | | | | | | |

The viscosities of the five formulations are listed in Table 2. The viscosities were measured using an Advanced Rheology Expansion System, made by Rheometric Scientific, with 25-mm parallel plates, at 1 % strain, a steady pre-shear rate of 1s⁻¹, and from the range of 1-100rad/s at room temperature.

**Table 2. Viscosities of Underfill Formulations**

| Formulation | Viscosity (cP) |
|---|---|
| 1 | 5,550 |
| 2 | 3,350 |
| 3 | 4,600 |
| 4 | 4,360 |
| 5 | 12,070 |

The viscosities of the samples are all within the ranges necessary to screen and stencil print.

Example 2. In order to find the proper B-staging conditions, two criteria are desired. These criteria are that, after the B-stage, the material must be non-tacky and not cured. To test whether these criteria were met, eight glass slides were bumped with 20-mil solder balls. About 20 mil of formulation 1 listed in Table 1 was then stenciled onto the glass slides. Each slide was then placed into a 130°C oven. Each slide was then B-staged for different times in the oven (30, 40, 50, 60, 70, 80, 90, or 100 minutes). After each slide had cooled, a wooden stick was placed atop the film to evaluate tackiness. If the wooden stick left a mark on the film, it was deemed tacky. If the wooden stick left no mark, it was considered non-tacky. To perform the cure test, each slide was placed through the eutectic solder reflow oven. After the slides had gone through the reflow profile, each slide was examined to determine if the solder had melted. When the solder melted, the curing time was considered as non-curable B-staging time: time left in the oven did not start the overall curing process. However, when the solder did not melt, the B-staging time was considered too long and already cured the underfill. The results are shown in Table 3.

**Table 3. B-staged Properties of Underfill**

| Time (Minutes at 130°C) | Tacky | Cured |
|---|---|---|
| 30 | Y | N |
| 40 | Y | N |
| 50 | N | N |
| 60 | N | N |
| 70 | N | Y |
| 80 | N | Y |
| 90 | N | Y |
| 100 | N | Y |

As shown in Table 3, when the underfill is B-staged for less than an optimal time the resulting film remained tacky to the touch. When the underfill is B-staged for longer than an optimal time, curing of the film is initiated and that has a detrimental affect on the attachment process. At 130 °C the optimal curing time is about 50 - 60 minutes. As the underfill's curing onset temperature is about 150 °C, temperatures above 130 °C are rarely utilized for B-staging. Temperatures below 130 °C may be utilized, but the time required to reach the proper B-stage state are longer the lower the temperature.

EXAMPLE 3. The proper Tg for B-staged underfill is critical. Diamond saws, as used for dicing wafers, can cleanly cut through materials having a Tg within the range of about 50 - 95°C. If the Tg is much higher than the target range, cracks can occur and break the B-staged underfill off the wafer. If the Tg is below 50°C, the film may become sticky during the dicing and stick to the diamond saw. Several formulations were made with low Tg and the observations are shown in Table 4. The temperature was ramped up at a rate of 5°C/min and the Tgs of each sample were measured by a TA Instruments thermomechanical analyzer using the TA analysis program. Formulation A and B are made similarly to the formulations in Table 1. Low Tg resins were used in these formulations (Formulation A consists of a mixture of EPON1001 and maleimides. Formulation B consists of EPON1001 and glycidal methacrylate). Table 4 also illustrates the Tg of the five samples of Table 1. The Tgs of these five samples fall within the diceable range (50-90°C) and have shown to be diceable.

**Table 4. Dicing Properties of Underfills**

| Formulation | Tg (°C) | Dicing Observations |
|---|---|---|
| A | 21 | Sticks to saw |
| B | 48 | Sticks to saw |
| | | |
| 1 | 62-64 | Cleanly diced |
| 2 | 79-84 | Cleanly diced |
| 3 | 58-60 | Cleanly diced |
| 4 | 87-94 | Cleanly diced |
| 5 | 74-80 | Cleanly diced |

Example 4. The viscosites of several different epoxy resin/fluxing agent mixtures were measured. Mixtures Z, Y, X, W, and V were each made by mixing 90 wt % epoxy resin (Z=EPON 1001, Y=EPON 1002, X=EPON 1004, W=EPON 1007, and V=EPON 1009) and 10% of fluxing agents PSPA (polysebaeic polyanhydride) together. Three solder balls, each having a 20-mil diameter, were placed on five separate copper substrates. One of the mixtures was printed on top of the solder balls on each substrate. Each printed substrates was then heated to 150°C for 2 minutes followed immediately by 190 °C for 1 minute. Observations of the solder are shown in Table 5. Also in Table 5, the viscosities of each mixture are reported. Using the single point analysis of Rheometric Scientific Instrument at 100 rad/s frequency, 5% strain temperature of 190°C, and 50mm parallel plates were used to determine each of the viscosities.

**Table 5. Solder Flux Observations**

| Sample | Viscosity at 190°C (cP) | Solder Flux Observation |
|---|---|---|
| Z | 874 | Complete Fluxing |
| Y | 2,905 | Complete Fluxing |
| X | 5,951 | Partial Fluxing |
| W | 16,615 | No Fluxing |
| V | 351,141 | No Fluxing |

As shown in Table 5, resins with a viscosity of about 5,900 cP or lower are preferable to accommodate the fluxing capability.

The degree to which fluxing occurs is measurable by the change in the radius of the solder balls. The radii of the solder balls containing various fluxing agents were measured and the results are shown in Table 6.

**Table 6. Fluxing Agents**

| Acid | PKa | Radius of Solder (mil) |
|---|---|---|
| Citric | 3.14 | 35.68 |
| Corfree M2 | 4.59 | 31.67 |
| L-cysteine | 7.85 | 10.00 |
| Resorcinol | 9.87 | 10.00 |
| Hydroquinone | 10.35 | 10.00 |

As shown in Table 6, citric acid and Corfree M2 were preferable among the fluxing agents that were tested. The flux capability of the formulations listed in Table 1 was tested using the method as described above. All the formulations in Table 1 show the enlargement of the solder ball in radius.

Example 5. The following example shows the effect of the type of catalyst on the curing behavior of the B-staged epoxy-oligomer based underfill coatings. The thermal curing profiles of the B-Staged coatings in DSC were used to prove the latent curing ability of the catalyst with the underfill formulations.

To prepare the composition, 100 parts of Epon 1001 F (Bisphenol-A glycidyl ether oligomer from Resolution Performance Products) was dissolved in 67 parts of γ-Butyrolactone (Aldrich Chemical) at 140°C for 1 hour. After cooling the homogeneous mixture to room temperature, 10 parts of Corefree M2 (Dodecanedioic Acid from DuPont as fluxing agent), 0.25 parts of defoamer Agitan 731 (Dee Foo Products), 0.5 parts of A-187 (Silquest), and 0.25 parts of a catalyst (as specified in Table 7) were added.

After all the components had been hand-mixed together, they were passed through a 3-Roll Mill and degassed in a vacuum oven at room temperature. All formulations were uniform and bubble free and had viscosity close to 3500 cP (Brookfield viscometer at 5 rpm).

To evaluate the curing, the underfill materials were dispensed on glass cover-slips (25x25 mm), by a stenciling process, to get 175 micron thick coating. The B-Stage was done in a convection oven, pre-heated to 140°C, for 30 minutes. After B-stage, all coatings were smooth, non-tacky and void free. These B-staged coatings were then used for the curing study.

The peak curing temperatures and the enthalpy of curing of the B-staged epoxy-ligomer based underfill systems (with different catalysts at 0.25% epoxy wt. basis) were recorded from the DSC curing profiles (ramped at 20°C /min.) and are shown in Table 7 . After the DSC samples had cooled down to room temperature, they were ramped again (@10°C/min. this time) to record the cured Tg. The DSC curing thermograms are shown in Figure1.

**Table1. Epoxy-oligomer based underfills with different catalysts**

| Formula | 2P4MZ | 2P4MZ -PMDA adduct | AMICURE 2PIP | Curezol 17Z | B-Stage Tg (°C) | Curing Peak (°C) | Curing Enthalpy (J/g) | Cured Tg (°C) |
|---|---|---|---|---|---|---|---|---|
| A | 0.25 | ----- | ----- | ----- | 83.9 | None | None | 84.0 |
| B | ----- | 0.25 | ------ | ------ | 39.5 | 219.4 | 22.4 | 63.1 |
| C | ----- | ------ | 0.25 | ---- | 41.0 | 218.4 | 33.4 | 68.3 |
| D | ---- | ------ | ---- | 0.25 | 39.4 | 213.2 | 18.4 | 52.1 |

As illustrated in Table 7 and Figure 1, 2P4MZ (in Formulation A) cures the coating completely during the B-stage step and no cure exotherm is observed in the DSC ramp. The identical Tgs after B-stage and the DSC cure (the cured Tg) also show significant enhancement during B-stage. This premature curing during B-stage results in poor flow and interferes with the solder interconnection during reflow.

For systems B-D, the curing exotherms are delayed beyond 200°C (beyond tin/lead liquidus at 183°C and close to typical lead-free solder melting temperatures). This delay in curing (compared to traditional 2P4MZ type imidazole curing agents) provides larger time window for the solder to flux and form interconnection before the underfill resin has cured. When solder-bumped chips, coated with formulations (B-D) were assembled by passing through the standard solder-reflow process, good fluxing, reflow and interconnection of the solder bumps to the substrate were established. In case of the bumped chips coated with Formulation A, the cured underfill material did not flow during reflow and solder interconnection could not be achieved.

Among the three formulations (B-D), Formulation C provides the highest B-stage Tg and curing enthalpy. The higher B-stage Tg is desirable to ensure clean dicing of the wafer. The higher curing enthalpy indicates broader B-stage window with more reaction taking place during the reflow (rather than the B-stage step).

## Claims

1. A B-stageable underfill encapsulant, wherein the encapsulant solidifies at a first temperature during the B-stage process to produce a smooth, non-tacky surface on a semiconductor wafer or silicon chip and wherein substantially the entire encapsulant cures at a second temperature that is higher than the first temperature, wherein the encapsulant comprises:
a) a thermal curable resin;
b) an imidazole phosphate salt catalyst;
c) at least one solvent;
d) one or more fluxing agents; and
e) optionally, one or more of the group consisting of surfactants, vetting agents, defoaming agents, coupling agents, inorganic fiters, adhesion promoters, flow additives, air release agents, and mixtures thereof,
wherein the one or more fluxing agent is selected form the group consisting of carboxylic acids, rosin gum, dodecanedioic acid, sebasic acid, maleic acid tartaric acid citric acid, alcohols, hydroxyl acid and hydroxyl base, polyols, ethylene glycol, glycerol, 3-[bis(glycidyl oxy methyl) methoxy]-1,2-propane diol, D-ribose D-cellobiose, cellulose, 3-cyclohexene-1,1-dimethanol, and mixtures thereof.

2. The encapsulant of claim 1, wherein the thermal curable resin is selected from the group consisting of monofunctional and multifunctional glycidyl ethers of Bisphenol-A, monofunctional and multifunctional glycidyl ethers of Bisphenol-F, aliphatic epoxies, aromatic epoxies, saturated epoxies, unsaturated epoxies, cycloaliphatic epoxy resins, epoxies having the structures 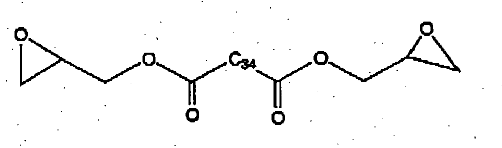 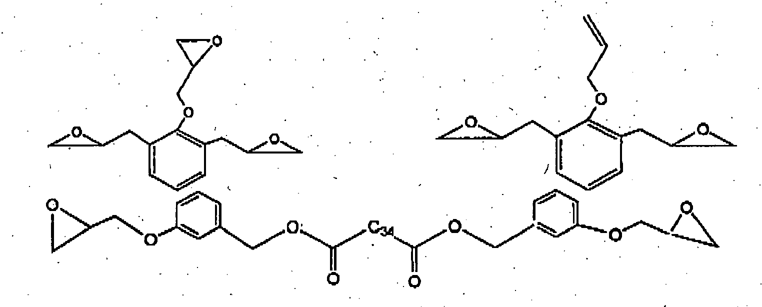 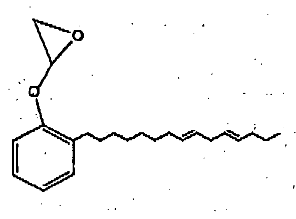 and mixtures thereof.

3. The encapsulant of claim 2, wherein the thermal curable resin is selected from the group consisting of 3,4-epoxycyciohexylmethyl-3,4 epoxycyclohexane carboxylate, vinylcyclohexene dioxide, 3.4-epoxy-6-methyl cyclohexyl methyl-3,4-epoxycyclohexane carboxylate, dicyclopentadiene dioxide, bisphenol A epoxy resin, bisphenol F epoxy resin, epoxy novolac resin, poly(phenyl glycidyl ether)-co-formaldehyde, biphenyl type epoxy resin, dicyclopentadiene-phenol epoxy resins, naphthalene epoxy resins, epoxy functional butadiene acylonitrile copolymers, epoxy functional polydimethyl siloxane, and mixtures thereof.

4. The encapsulant of claim 3 wherein the thermal curable resin comprises in the range of about 20 wt % to about 90 wt % of the encapsulant.

5. The encapsulant of claim 4, wherein the thermal curable resin comprises in the range of about 20 wt % to about 80 wt % of the encapsulant.

6. The encapsulant of claim 1, wherein the imidazole phosphate salt comprises 2-phenyl imidazole dihydrogen phosphate salt.

7. The encapsulant of claim 6, wherein the imidazole phosphate salt comprises a phosphoric acid content.

8. The encapsulant of claim 1, wherein the imidazole phosphate salt comprises in the range of about 0.01 wt% to about 10 wt% of the encapsulant.

9. The encapsulant of claim 8. wherein the imidazole phosphate salt comprises in the range of about 0.1 wt% to about 5 wt% of the encapsulant.

10. The encapsulant of claim 1, wherein the at least one solvent is selected from the group comprising solvents that are stable and dissolve the epoxy resins in the composition.

11. The encapsulant of claim 9, wherein the at least one solvent is selected from the group consisting of ketones, esters, alcohols, ethers, γ-butyrolactone and propylene glycol methyl ether acetate (PGMEA) and mixtures thereof.

12. The encapsulant of claim 11, wherein the at least one solvent is selected from the group consisting of γ-butymlactone, propylene glycol methyl ether acetate (PGMEA) and mixtures thereof.

13. The encapsulant of claim 9, wherein the solvent comprises up to about 80 wt % of the encapsulant.

14. The encapsulant of claim 1, wherein the at least one flux agent comprises rosin gum, dodecanedioic acid, adipic acid, or mixtures thereof.

15. The encapsulant of claim 14, wherein the at least one flux agent comprises in the range of about 0.5 wt % to about 20 wt % of the encapsulant.

16. The encapsulant of claim 15, wherein the at least one flux agent comprises in the range of about 1 wt % to about 10 wt % of the encapsulant

17. The encapsulant of claim 1, wherein the encapsulant further comprises one or more of group consisting of surfactants, wetting agents, defoaming agents, coupling agents, inorganic fillers, adhesion promoters, flow additives, air release agents, and mixtures thereof.

18. The encapsulant of claim 17, wherein the surfactant is selected from the group consisting of organic acrylic polymers, silicones, epoxy-silicones, polyoxyethylene/polyoxypropylene block copolymers, ethylene diamine based polyoxyethylene/polyoxypropylene block copolymers, polyol-based polyoxyalkylenes, fatty alcohol-based polyoxyalkylenes, fatty alcohol polyoxyalkylene alkyl ethers and mixtures whereof.

19. A silicon wafer having a B-stageable underfill composition that is curate at a single temperature deposited on one face of the wafer, the B-stageable composition comprising
a) a thermal curable resin;
b) an imidazole phosphate salt catalyst;
c) at least one solvent;
d) one or more fluxing agents; and
e) optionally, one or more additive selected from the group consisting of surfactant, wetting agents, defoaming agents, coupling agents, inorganic fillers, adhesion promoters, flow additives, air release agents, and mixtures thereof, wherein the at least one fluxing agent is selected from the group consisting of carboxylic acids, rosin gum, dodecanedioic acid, adipic acid, sebasic acid, maleic acid, tartaric add, citric acid, alcohols, hydroxyl acid and hydroxyl base, polyols, ethylene glycol, glycerol, 3-[bis(glycidyl oxy methyl) methoxy]-1,2-propane diol, D-ribose, D-cellobiose, cellulose, 3-cyclohexene-1,1-dimethanol, and mixtures thereof.

20. A method of preparing one or more silicon chips, comprising the steps of
a) applying the encapsulant of claim 1 to a semiconductor wafer.
b) B-stage processing the encapsulant on the semiconductor wafer so that the encapsulant solidifies into a smooth, non-tacky coating, and
c) dicing the semiconductor wafer into individual silicon chips.

21. The method of claim 20, wherein the encapsulant is applied to the semiconductor wafer via spin coating, screen printing or stencil printing.

22. A method of preparing an electronic package comprising the steps of
a) applying the encapsulant of claim 1 to a semiconductor wafer;
b) B-stage processing the encapsulant on the semiconductor wafer so that the encapsulant solidifies into a smooth, non-tacky coating;
c) dicing the semiconductor wafer into multiple silicon chips, with each chip having a first side coated with the encapsulant;
d) placing one or more silicon chips on a substrate so that the first side of the silicon chip is adjacent to the substrate; and
e) heating the one or more silicon chips and substrate to a temperature sufficient to form interconnections between the one or more silicon chips and the substrate.

23. The method of claim 22, comprising the additional step of placing an unfilled liquid curable fluxing material on the substrate before the silicon chip is placed on the substrate.

24. The method of claim 23, wherein the unfilled liquid curable fluxing material comprises
a) a thermal curable epoxy resin;
b) an imidazole-anhydride adduct; and
c) at least one fluxing agent,
wherein the imidazole-anhydride adduct comprises an adduct of 2-phenyl-4-methyl imidazole and pyromellitic dianhydride.

## Patentansprüche

1. B-Stufen-fähiges Unterfüllungsverkapselungsmittel, wobei sich das Verkapselungsmittel bei einer ersten Temperatur während des B-Stufen-Prozesses unter Herstellung einer glatten, nicht-klebrigen Oberfläche auf einem Halbleiter-Wafer oder Silicium-Chip verfestigt und wobei im Wesentlichen das gesamte Verkapselungsmittel bei einer zweiten Temperatur härtet, die höher ist als die erste Temperatur, wobei das Verkapselungsmittel umfasst:
a) ein thermisch härtbares Harz;
b) einen Imidazolphosphatsalz-Katalysator;
c) wenigstens ein Lösungsmittel;
d) ein oder mehrere Flussmittel und
e) gegebenenfalls eines oder mehrere aus der Gruppe, bestehend aus oberflächenaktiven Mitteln, Netzmitteln, Entschäumungsmitteln, Haftvermittlern, anorganischen Füllstoffen, Adhäsionsbeschleunigern, Fließadditiven, Luftfreisetzungsmitteln und Gemischen davon,
wobei das eine Flussmittel oder die mehreren Flussmittel ausgewählt ist/sind aus der Gruppe, bestehend aus Carbonsäuren, Kolophoniumgummi, Dodecandisäure, Sebacinsäure, Maleinsäure, Weinsäure, Citronensäure, Alkoholen, Hydroxylsäure und Hydroxylbase, Polyolen, Ethylenglykol, Glycerin, 3-[Bis(glycidyloxymethyl)methoxy]-1,2-propandiol, D-Ribose, D-Cellobiose, Cellulose, 3-Cyclohexen-1,1-dimethanol und Gemischen davon.

2. Verkapselungsmittel gemäß Anspruch 1, wobei das thermisch härtbare Harz ausgewählt ist aus der Gruppe, bestehend aus monofunktionellen und multifunktionellen Glycidylethern von Bisphenol A, monofunktionellen und multifunktionellen Glycidylethern von Bisphenol F, aliphatischen Epoxiden, aromatischen Epoxiden, gesättigten Epoxiden, ungesättigten Epoxiden, cycloaliphatischen Epoxidharzen, Epoxiden, die die Strukturen 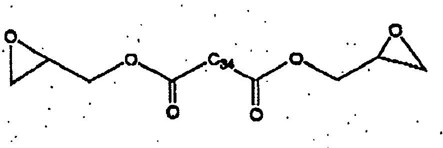 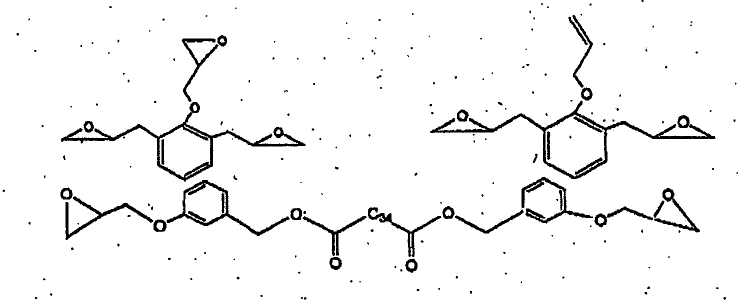 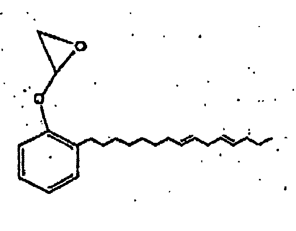 haben, und Gemischen davon.

3. Verkapselungsmittel gemäß Anspruch 2, wobei das thermisch härtbare Harz ausgewählt ist aus der Gruppe, bestehend aus 3,4-Epoxycyclohexylmethyl-3,4-epoxycyclohexancarboxylat, Vinylcyclohexendioxid, 3,4-Epoxy-6-methylcyclohexylmethyl-3,4-epoxycyclohexancarboxylat, Dicyclopentadiendioxid, Bisphenol A-Epoxidharz, Bisphenol F-Epoxidharz, Epoxid-Novolac-Harz, Poly(phenylglycidylether)-co-formaldehyd, Epoxidharz des Biphenyltyps, Dicyclopentadien-Phenolepoxid-Harzen, Naphthalinepoxidharzen, Epoxid-funktionellen Butadien-Acrylnitril-Copolymeren, Epoxid-funktionellem Polydimethylsiloxan und Gemischen davon.

4. Verkapselungsmittel gemäß Anspruch 3, wobei das thermisch härtbare Harz einen Anteil im Bereich von etwa 20 Gewichts-% bis etwa 90 Gewichts-% des Verkapselungsmittels ausmacht.

5. Verkapselungsmittel gemäß Anspruch 4, wobei das thermisch härtbare Harz einen Anteil im Bereich von etwa 20 Gewichts-% bis etwa 80 Gewichts-% des Verkapselungsmittels ausmacht.

6. Verkapselungsmittel gemäß Anspruch 1, wobei das Imidazolphosphatsalz 2-Phenylimidazoldihydrogenphosphatsalz umfasst.

7. Verkapselungsmittel gemäß Anspruch 6, wobei das Imidazolphosphatsalz einen Phosphorsäuregehalt umfasst.

8. Verkapselungsmittel gemäß Anspruch 1, wobei das Imidazolphosphatsalz einen Anteil im Bereich von etwa 0,01 Gewichts-% bis etwa 10 Gewichts-% des Verkapselungsmittels ausmacht.

9. Verkapselungsmittel gemäß Anspruch 8, wobei das Imidazolphosphatsalz einen Anteil im Bereich von etwa 0,1 Gewichts-% bis etwa 5 Gewichts-% des Verkapselungsmittels ausmacht.

10. Verkapselungsmittel gemäß Anspruch 1, wobei das wenigstens eine Lösungsmittel ausgewählt ist aus der Gruppe, umfassend Lösungsmittel, die stabil sind und die Epoxidharze in der Zusammensetzung lösen.

11. Verkapselungsmittel gemäß Anspruch 9, wobei das wenigstens eine Lösungsmittel ausgewählt ist aus der Gruppe, bestehend aus Ketonen, Estern, Alkoholen, Ethern, γ-Butyrolacton und Propylenglykolmethyletheracetat (PGMEA) und Gemischen davon.

12. Verkapselungsmittel gemäß Anspruch 11, wobei das wenigstens eine Lösungsmittel ausgewählt ist aus der Gruppe, bestehend aus γ-Butyrolacton, Propylenglykolmethyletheracetat (PGMEA) und Gemischen davon.

13. Verkapselungsmittel gemäß Anspruch 9, wobei das Lösungsmittel bis zu etwa 80 Gewichts-% des Verkapselungsmittels ausmacht.

14. Verkapselungsmittel gemäß Anspruch 1, wobei das wenigstens eine Flussmittel Kolophoniumgummi, Dodecandisäure, Adipinsäure oder Gemische davon umfasst.

15. Verkapselungsmittel gemäß Anspruch 14, wobei das wenigstens eine Flussmittel einen Anteil im Bereich von etwa 0,5 Gewichts-% bis etwa 20 Gewichts-% des Verkapselungsmittels ausmacht.

16. Verkapselungsmittel gemäß Anspruch 15, wobei das wenigstens eine Flussmittel einen Anteil im Bereich von etwa 1 Gewichts-% bis etwa 10 Gewichts-% des Verkapselungsmittels ausmacht.

17. Verkapselungsmittel gemäß Anspruch 1, wobei das Verkapselungsmittel außerdem eines oder mehrere aus der Gruppe, bestehend aus oberflächenaktiven Mitteln, Netzmitteln, Entschäumungsmitteln, Haftvermittlern, anorganischen Füllstoffen, Adhäsionsbeschleunigern, Fließadditiven, Luftfreisetzungsmitteln und Gemischen davon umfasst.

18. Verkapselungsmittel gemäß Anspruch 17, wobei das oberflächenaktive Mittel ausgewählt ist aus der Gruppe, bestehend aus organischen Acrylpolymeren, Silikonen, Epoxid-Silikonen, Polyoxyethylen/Polyoxypropylen-Blockcopolymeren, Polyoxyethylen/Polyoxypropylen-Blockcopolymeren auf Ethylendiaminbasis, Polyoxyalkylenen auf Polyolbasis, Polyoxyalkylenen auf Fettalkoholbasis, Fettalkoholpolyoxyalkylenalkylethern und Gemischen davon.

19. Siliciumwafer, der eine B-Stufen-fähige Unterfüllungszusammensetzung hat, die bei einer einzigen Temperatur härtbar ist, abgeschieden auf einer Seite des Wafers, wobei die B-Stufen-fähige Zusammensetzung umfasst.
a) ein thermisch härtbares Harz;
b) einen Imidazolphosphatsalz-Katalysator;
c) wenigstens ein Lösungsmittel;
d) ein oder mehrere Flussmittel und
e) gegebenenfalls ein oder mehrere Additiv(e), ausgewählt aus der Gruppe, bestehend aus oberflächenaktiven Mitteln, Netzmitteln, Entschäumungsmitteln, Haftvermittlern, anorganischen Füllstoffen, Adhäsionsbeschleunigern, Fließadditiven, Luftfreisetzungsmitteln und Gemischen davon,
wobei das eine Flussmittel oder die mehreren Flussmittel ausgewählt ist/sind aus der Gruppe, bestehend aus Carbonsäuren, Kolofoniumgummi, Dodecandisäure, Sebacinsäure, Maleinsäure, Weinsäure, Citronensäure, Alkoholen, Hydroxylsäure und Hydroxylbase, Polyolen, Ethylenglykol, Glycerin, 3-[Bis(glycidyloxymethyl)methoxy}-1,2-propandiol, D-Ribose, D-Cellobiose, Cellulose, 3-Cyclohexen-1,1-dimethanol und Gemischen davon.

20. Verfahren zur Herstellung eines Silicium-Chip oder mehrere Silicium-Chips, umfassend die Schritte:
a) Auftragen eines Verkapselungsmittels von Anspruch 1 auf einen Halbleiter-Wafer;
b) B-Stufen-Verarbeitung des Verkapselungsmittels auf dem Halbleiter-Wafer, so dass sich das Verkapselungsmittel zu einer glatten, nicht-klebrigen Beschichtung verfestigt, und
c) Zerteilen des Halbleiter-Wafers in einzelne Silicium-Chips.

21. Verfahren gemäß Anspruch 20, wobei das Verkapselungsmittel durch Spin-Beschichtung, Siebdruck oder Schablonendruck auf den Halbleiter-Wafer aufgetragen wird.

22. Verfahren zur Herstellung eines elektronischen Bauelements, umfassend die Schritte:
a) Auftragen des Verkapselungsmittels von Anspruch 1 auf einen Halbleiter-Wafer;
b) B-Stufen-Verarbeitung des Verkapselungsmittels auf dem Halbleiter-Wafer, so dass sich das Verkapselungsmittel zu einer glatten, nicht-klebrigen Beschichtung verfestigt;
c) Zerteilen des Halbleiter-Wafers in mehrere Silicium-Chips, wobei jeder Chip eine erste Seite mit dem Verkapselungsmittel beschichtet hat;
d) Platzieren eines Silicium-Chip oder mehrerer Silicium-Chips auf ein Substrat, so dass die erste Seite des Silicium-Chips an das Substrat angrenzend ist, und
e) Erwärmen des einen Silicium-Chip oder der mehreren Silicium-Chips und des Substrats auf eine Temperatur, die ausreichend ist, um zwischen dem einen Silicium-Chip oder den mehreren Silicium-Chips und dem Substrat Verbindungen zu bilden.

23. Verfahren gemäß Anspruch 22, umfassend den zusätzlichen Schritt eines Platzierens eines ungefüllten flüssigen härtbaren Flussmaterials auf das Substrat, bevor der Silicium-Chip auf das Substrat platziert wird.

24. Verfahren gemäß Anspruch 23, wobei das ungefüllte flüssige härtbare Flussmaterial umfasst:
a) ein thermisch härtbares Epoxidharz;
b) ein Imidazol-Anhydrid-Addukt und
c) wenigstens ein Flussmittel,
wobei das Imidazol-Anhydrid-Addukt ein Addukt von 2-Phenyl-4-methylimidazol und Pyromellitsäuredianhydrid umfasst.

## Revendications

1. Produit d'encapsulation pour remplissage sous-jacent amenable au stade B, dans lequel le produit d'encapsulation se solidifie à une première température pendant la maturation au stade B pour produire une surface lisse non collante sur une tranche de semi-conducteur ou une puce de silicium et dans lequel sensiblement tout le produit d'encapsulation durcit à une seconde température qui est plus élevée que la première température, le produit d'encapsulation comprenant :
a) une résine thermodurcissable ;
b) un catalyseur du type phosphate d'imidazole ;
c) au moins un solvant ;
d) un ou plusieurs agents fondants ; et
e) facultativement un ou plusieurs membres du groupe formé par des agents tensio-actifs, agents mouillants, agents antimousse, agents de couplage, charges minérales, promoteurs d'adhérence, additifs d'écoulement, agents d'évacuation de l'air, et leurs mélanges,
dans lequel le ou les agents fondants sont choisis dans le groupe formé par des acides carboxyliques, la gomme de colophane, l'acide dodécanedioïque, l'acide sébacique, l'acide maléique, l'acide tartrique, l'acide citrique, des alcools, un acide hydroxylique et une base hydroxylique, des polyols, l'éthylèneglycol, le glycérol, le 3-[bis(glycidyloxyméthyl)-méthoxy]-1,2-propanediol, le D-ribose, le D-cellobiose, la cellulose, le 3-cyclohexène-1,1-diméthanol, et leurs mélanges.

2. Produit d'encapsulation selon la revendication 1, dans lequel la résine thermodurcissable est choisie dans le groupe formé par les éthers glycidyliques monofonctionnels et multifonctionnels de bisphénol A, les éthers glycidyliques monofonctionnels et multifonctionnels de bisphénol F, les époxydes aliphatiques, les époxydes aromatiques, les époxydes saturés, les époxydes insaturés, les époxydes cycloaliphatiques, les époxydes ayant les structures 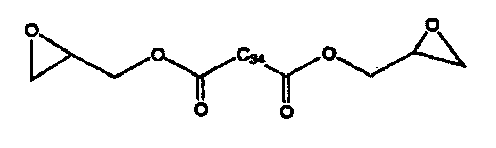 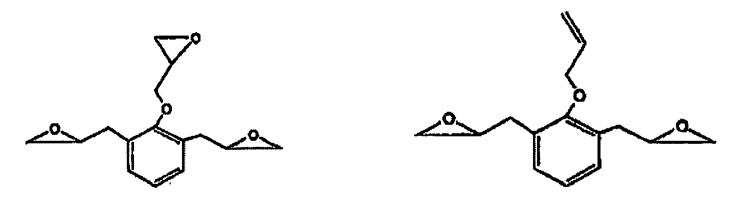 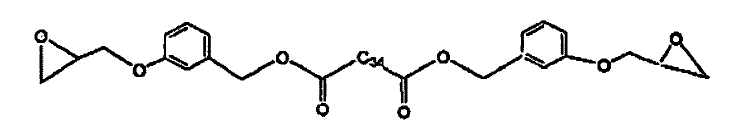 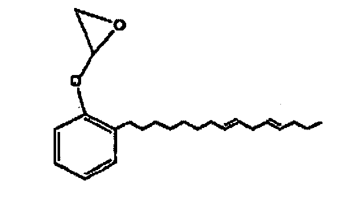 et leurs mélanges.

3. Produit d'encapsulation selon la revendication 2, dans lequel la résine thermodurcissable est choisie dans le groupe formé par le 3,4-époxycyclohexane-carboxylate de 3,4-époxycyclohexylméthyle, le dioxyde de vinylcyclohexène, le 3,4-époxycyclohexane-carboxylate de 3,4-époxy-6-méthyl-cyclohexylméthyle, le dioxyde de dicyclopentadiène, une résine époxy de bisphénol A, une résine époxy de bisphénol F, une résine époxy-novolaque, un poly(éther de phényle et de glycidyle)-co-formaldéhyde, une résine époxy du type biphényle, des résines époxy de dicyclopentadiène-phénol, des résines époxy de naphtalène, des copolymères butadiène-acrylonitrile à fonction époxy, un polydiméthylsiloxane à fonction époxy, et leurs mélanges.

4. Produit d'encapsulation selon la revendication 3, dans lequel la résine thermodurcissable constitue environ 20 % en poids à environ 90 % en poids du produit d'encapsulation.

5. Produit d'encapsulation selon la revendication 4, dans lequel la résine thermodurcissable constitue environ 20 % en poids à environ 80 % en poids du produit d'encapsulation.

6. Produit d'encapsulation selon la revendication 1, dans lequel le phosphate d'imidazole comprend du dihydrogénophosphate de 2-phénylimidazole.

7. Produit d'encapsulation selon la revendication 6, dans lequel le phosphate d'imidazole comprend de l'acide phosphorique.

8. Produit d'encapsulation selon la revendication 1, dans lequel le phosphate d'imidazole constitue environ 0,01 % en poids à environ 10 % en poids du produit d'encapsulation.

9. Produit d'encapsulation selon la revendication 8, dans lequel le phosphate d'imidazole constitue environ 0,1 % en poids à environ 5 % en poids du produit d'encapsulation.

10. Produit d'encapsulation selon la revendication 1, dans lequel ledit au moins un solvant est choisi dans le groupe formé par des solvants qui sont stables et qui dissolvent les résines époxy dans la composition.

11. Produit d'encapsulation selon la revendication 9, dans lequel ledit au moins un solvant est choisi dans le groupe formé par les cétones, les esters, les alcools, les éthers, la γ-butyrolactone et l'acétate d'éther méthylique de propylèneglycol (PGMEA), et leurs mélanges.

12. Produit d'encapsulation selon la revendication 11, dans lequel ledit au moins un solvant est choisi dans le groupe formé par la γ-butyrolactone, l'acétate d'éther méthylique de propylèneglycol (PGMEA) et leurs mélanges.

13. Produit d'encapsulation selon la revendication 9, dans lequel le solvant constitue jusqu'à environ 80 % en poids du produit d'encapsulation.

14. Produit d'encapsulation selon la revendication 1, dans lequel ledit au moins un agent fondant comprend de la gomme de colophane, de l'acide dodécanedioïque, de l'acide adipique ou des mélanges d'entre eux.

15. Produit d'encapsulation selon la revendication 14, dans lequel ledit au moins un agent fondant constitue environ 0,5 % en poids à environ 20 % en poids du produit d'encapsulation.

16. Produit d'encapsulation selon la revendication 15, dans lequel ledit au moins un agent fondant constitue environ 1 % en poids à environ 10 % en poids du produit d'encapsulation.

17. Produit d'encapsulation selon la revendication 1, dans lequel le produit d'encapsulation comprend de plus un ou plusieurs membres du groupe formé par des agents tensio-actifs, agents mouillants, agents antimousse, agents de couplage, charges minérales, promoteurs d'adhérence, additifs d'écoulement, agents d'évacuation de l'air, et leurs mélanges.

18. Produit d'encapsulation selon la revendication 17, dans lequel l'agent tensio-actif est choisi dans le groupe formé par des polymères acryliques organiques, des silicones, des époxy-silicones, des copolymères séquencés polyoxyéthylène/polyoxypropylène, des copolymères séquencés polyoxyéthylène/polyoxypropylène à base d'éthylènediamine, des polyoxyalkylènes à base de polyol, des polyoxyalkylènes à base d'alcool gras, des éthers alkyliques de polyoxyalkylènes à base d'alcool gras, et leurs mélanges.

19. Tranche de silicium ayant une composition de remplissage sous-jacent amenable au stade B qui est durcissable à une température unique, déposée sur une face de la tranche, la composition amenable au stade B comprenant
a) une résine thermodurcissable ;
b) un catalyseur du type phosphate d'imidazole ;
c) au moins un solvant ;
d) un ou plusieurs agents fondants ; et
e) facultativement un ou plusieurs additifs choisis dans le groupe formé par des agents tensio-actifs, agents mouillants, agents antimousse, agents de couplage, charges minérales, promoteurs d'adhérence, additifs d'écoulement, agents d'évacuation de l'air, et leurs mélanges,
dans laquelle ledit au moins un agent fondant est choisi dans le groupe formé par des acides carboxyliques, la gomme de colophane, l'acide dodécanedioïque, l'acide adipique, l'acide sébacique, l'acide maléique, l'acide tartrique, l'acide citrique, des alcools, un acide hydroxylique et une base hydroxylique, des polyols, l'éthylèneglycol, le glycérol, le 3-[bis(glycidyloxyméthyl)méthoxy]-1,2-propanediol, le D-ribose, le D-cellobiose, la cellulose, le 3-cyclohexène-1,1-diméthanol, et leurs mélanges.

20. Procédé de préparation d'une ou plusieurs puces de silicium, comprenant les étapes de :
a) application du produit d'encapsulation selon la revendication 1 à une tranche de semi-conducteur ;
b) maturation au stade B du produit d'encapsulation sur la tranche de semi-conducteur en sorte que le produit d'encapsulation se solidifie en un revêtement lisse non collant ; et
c) découpage de la tranche de semi-conducteur en puces de silicium individuelles.

21. Procédé selon la revendication 20, dans lequel le produit d'encapsulation est appliqué à la tranche de semi-conducteur par dépôt par centrifugation, impression sérigraphique ou impression au pochoir.

22. Procédé de préparation d'un boîtier électronique, comprenant les étapes de
a) application du produit d'encapsulation selon la revendication 1 à une tranche de semi-conducteur ;
b) maturation au stade B du produit d'encapsulation sur la tranche de semi-conducteur en sorte que le produit d'encapsulation se solidifie en un revêtement lisse non collant ;
c) découpage de la tranche de semi-conducteur en puces de silicium multiples, chaque puce ayant une première face revêtue du produit d'encapsulation ;
d) mise en place d'une ou plusieurs puces de silicium sur un substrat en sorte que la première face de la puce de silicium soit adjacente au substrat ; et
e) chauffage de la ou des puces de silicium et du substrat à une température suffisante pour former des interconnexions entre la ou les puces de silicium et le substrat.

23. Procédé selon la revendication 22, comprenant l'étape supplémentaire de mise en place d'un produit fondant durcissable liquide non chargé sur le substrat avant que la puce de silicium soit mise en place sur le substrat.

24. Procédé selon la revendication 23, dans lequel le produit fondant durcissable liquide non chargé comprend
a) une résine époxy thermodurcissable ;
b) un produit d'addition imidazole-anhydride ; et
c) au moins un agent fondant ;
le produit d'addition imidazole-anhydride comprenant un produit d'addition de 2-phényl-4-méthylimidazole et de dianhydride pyromellitique.
